# EUROPEAN PATENT APPLICATION

(11) **EP 4 015 677 A1**
(43) Date of publication of application: **22.06.2022**
(21) Application number: 20216233.5
(22) Date of filing: 21.12.2020
(51) Int. Cl.: C30B 29/06, C30B 29/36, C30B 33/06, B23K 26/53, B23K 103/00, B23K 101/40

(54) **METHODS FOR SEPARATING A SUBSTRATE FROM A WAFER OR INGOT AND APPARATUSES FOR SEPARATING A SUBSTRATE FROM A WAFER OR INGOT**

(71) Applicant: Nickl Technologies GmbH, 85604 Zorneding (DE)
(72) Inventor: Nickl, Julius, 85665 Moosach (DE)
(74) Representative: Sommer, Andrea

(57) **Abstract**

The invention relates to methods for separating a substrate from a wafer or ingot by forming of defects 14a and resulting voids 16 within the wafer or ingot by means of a laser beam interaction, wherein in some methods a volume-changing separation medium is used and in other methods a mechanical force to separate the substrate from the wafer or ingot. Further, the invention relates to apparatuses for separating a substrate from a wafer or ingot.

## Description

The present disclosure relates to methods for separating a substrate from a wafer or ingot by forming of defects 14a and resulting voids 16 within the wafer or ingot by means of a laser beam interaction, wherein in some methods a volume-changing separation medium is used and in other methods a mechanical force to separate the substrate from the wafer or ingot. Further, the present disclosure relates to apparatuses for separating a substrate from a wafer or ingot.

Nowadays, most of microelectronic, optoelectronic, and microfabrication applications require wafers, i.e. very thin layers of crystalline materials as a starting material for fabricating of various products used in all different technological fields. In the arts there are several methods know to cut thin layers from a crystalline material ingot. Most of them use wire saw tool that have a high environmental impact and encounters various limitations, in particular a significant loss of crystalline material due to the sawing process and the whole process is very time consuming, in particular in case silicon carbide (SiC) having a hardness comparable to diamond and boron nitride.

Due to the high costs and value of these materials and the increasing demand on the market, in particular for computer industry and high frequent applications, there is still a high demand for new methods for separating substrates from a wafer or ingot in the art.

The invention addresses these problems and provides a number of new very efficient methods and apparatuses to perform "wafer splitting", i.e. separating a substrate from a wafer or ingot.

### DESCRIPTION OF THE INVENTION

Using the methods or apparatuses according to the invention, one or more of the following advantages can be realized: less material loss, lower process costs, reduce of undesired fraction, which could lead to breakage of the wafer and very low operating costs compared to wire sawing.

If one only considers the sawing loss, >50% more wafers can be produced from a wafer, ingot, boule or puck by eliminating the sawing step in the wafer production. Due to the stresses that a wafer sustains during sawing, the wafers cannot be manufactured thinner. The inventive method and apparatus used for the separation/splitting can reduce the stresses during the separation/splitting process and consequently the wafer thickness can be reduced up to 30%. In summary, this means that the yield from the wafer, ingot, boule or puck can be more than doubled if compared to know fracturing methods using a wire saw.

The following new very efficient methods and apparatuses for "wafer splitting", i.e. separating a substrate from a wafer or ingot can be used either for the production of, in particular homogeneous, wafers, substrates from wafers, ingots, boules or pucks made of SiC or for the production of substrates from other materials which are transparent for electromagnetic radiation with a suitable wavelength. The material of the wafer, ingot, boules or pucks and thus of the separated and detached substrate or disc include diamond, silicon (Si), silicon carbide (SiC), germanium (Ga), gallium arsenide (GaAs), gallium nitride (GaN), aluminium nitride (AIN), indium nitride (InN), aluminium gallium nitride (AIGaN), indium gallium nitride (InGaN), aluminium indium gallium nitride (AllnGaN) and indium phosphide (InP).

As used herein, a "wafer" or "ingot" or "puck" or "boule" refers to a material, such as a mono or multi crystalline semiconductor material that is divisible into at least two portions having substantially the same material, lateral dimensions (e.g., diameter, or length and width) as the second portion, and having sufficient thickness (i) to be surface processed (e.g., lapped and/or etched and/or polished) to support epitaxial deposition of one or more semiconductor layers, and optionally (ii) to be free standing if and when separated from a rigid carrier. In the following only the terms wafer and ingot will be used. However, boule and puck can be used for the same object. In certain embodiments, the substrate may have a generally cylindrical shape, and/or may have a thickness of at least about one or more of the following thicknesses: 25 µm , 50 µm,100 µm, 150 µm, 200 µm, 250 µm, 300 µm, 350 µm, 500 µm, 750 µm, 1 mm, 2 mm, 3 mm, 5 mm, 10 mm.

In certain embodiments, a "wafer" means a wafer that is divisible into two thinner wafers. The shape of the wafers can be preferably circular or rectangular having a size of usually 0.5 x 0.5 cm, 1 cm x 1 cm, 5 cm x 5 cm, 10 cm x 10 cm, 15 cm x 15 cm, 20 cm x 20 cm, 30 cm x 30 cm or 35 cm x 35 cm or having a diameter of 0.5 cm, 1 cm, 5 cm, 10 cm or 4 inches, 15 cm or 6 inches, 20 cm or 8 inches, 30 cm or 12 inches, 35 cm, 40 cm or 16 inches.

Methods disclosed herein may be applied to semiconductor materials of various crystalline materials, of both single or mono crystalline, polycrystalline varieties as well as amorphous structures. In certain embodiments, methods disclosed herein may utilize cubic, hexagonal, and other crystal structures, and may be directed to crystalline materials having on-axis and off-axis crystallographic orientations. In certain embodiments, methods disclosed herein may be applied to semiconductor materials. Exemplary materials include, but are not limited to, Si, GaAs, SiC and diamond. In certain embodiments, such methods may utilize single crystalline semiconductor materials having hexagonal crystal structure, such as 4H-SiC, 6H-SiC, or Group III nitride materials (e.g., GaN, AIN, InN, InGaN, AIGaN, or AllnGaN). Various illustrative embodiments described hereinafter mention SiC generally or 4H-SiC specifically, but it is to be appreciated that any suitable crystalline material may be used. Among the various SiC polytypes, the 4H-SiC polytype is particularly attractive for power electronic devices due to its high thermal conductivity, wide bandgap, and isotropic carrier mobility. Bulk SiC may be grown on-axis (i.e., with no intentional angular deviation from the c-plane thereof, suitable for forming undoped or semi-insulating material) or off-axis (typically departing from a grown axis such as the c-axis by a non-zero angle, typically in a range of from 0.5 to 10 degrees (or a subrange thereof such as 2 to 6 degrees or another subrange), as may be suitable for forming N-doped or highly conductive material). Embodiments disclosed herein may apply to on-axis and off-axis crystalline materials, as well as doped and unintentionally doped crystalline semiconductor materials. Doped semiconductor material (e.g., N-doped SiC) exhibits some infrared absorption, thus requiring the use of higher laser power than undoped material to impart defect trace. In certain embodiments, crystalline material may include single crystal material, and may further include single crystal semiconductor material. Certain embodiments disclosed herein may utilize on-axis 4H-SiC or vicinal (off-axis) 4H-SiC having an offcut in a range of from 1 to 10 degrees, or from 2 to 6 degrees, or about 4 degrees.

Certain embodiments herein may use substrates of doped or undoped SiC, such as SiC ingots, which may be grown by physical vapor transport (PVT) or other conventional ingot fabrication methods. If doped SiC is used, such doping may render the SiC N-type or semi-insulating in character. In certain embodiments, a N-type SiC ingot is intentionally doped with nitrogen. In certain embodiments, a N-type SiC ingot includes resistivity values within a range of 0.015 to 0.028 Ohm-cm. In certain embodiments, a SiC ingot may have resistivity values that vary with vertical position, such that different substrate portions (e.g., wafers) have different resistivity values, which may be due to variation in bulk doping levels during ingot growth. In certain embodiments, a SiC ingot may have doping levels that vary horizontally, from a higher doping region proximate to a center of the ingot to a lower doping level proximate to a lateral edge thereof. Variation in ingot doping and resistivity with respect to vertical and horizontal position may render it necessary to adjust laser damage formation parameters for formation of different reduced thickness portions (e.g., wafers) of a substrate (e.g., an ingot) and/or during formation of a single reduced thickness portion of a substrate. In certain embodiments, resistivity is greatest proximate to an exposed surface of an ingot and is lowest proximate to a growth seed. A reduction in resistivity corresponds to an increase in doping and an increase in laser absorption.

In the method of this invention commercially available wafers having already formed voids within the wafer or ingot by means of a laser beam interaction may also be used.

Substrates of the crystalline material separated according to methods of the invention can then be used for the production of LEDs, high power devices, diodes, discrete and integrated transistors, substrate for epitaxy of SiC material, high-frequency applications, preferably 5G antennas or microwave transmitters.

In addition, the invention can be used in the production of other technical, thin substrates, the minimum thickness of which was previously predetermined by the wire saw, such as camera lenses, in particular camera lenses made of sapphire for mobile communication or other optical applications.

In a first embodiment, the invention relates to a method for separating a substrate from a wafer or ingot comprising the following steps:
(i) forming of defects 14a and resulting voids 16 within the wafer or ingot by means of a laser beam interaction;
(ii) inserting a separation medium into at least parts of the voids 16 including defects 14a;
(iii) effecting a volume change of the separation medium within the voids 16 including defects 14;
(iv) splitting the substrate off the wafer or ingot by means of the volume change of the separation medium.

Optionally this method may comprise the additional step of
(v) effecting the separation of the substrate from the wafer or ingot by a mechanical means.

This further step is preferably performed in case the volume change has only effected the separation partly.

The substrate as used in this method is a wafer or ingot consisting of a crystalline material and is preferably a multi or mono crystalline material. Preferably the crystalline material is selected from silicon, gallium arsenide, silicon carbide (SiC) and diamond, in a more preferred embodiment the crystalline material a silicon or silicon carbide material, more preferably the crystalline material is a silicon carbide material.

One of the fundamental features of this invention is the step of
(i) forming of defects 14a and resulting voids 16 within the wafer or ingot by means of a laser beam interaction.
The goal of this step is to create a kind of open porosity in a split plane 17 of the wafer or ingot to be separated that is also preferably open to the outside along the edge.

The defects 14a and resulting voids 16 are arranged in a row or a specific pattern to build a defect trace 14. At least one defect trace, preferably more than one defect trace 14 are effected into the wafer or ingot. More preferably, the entire wafer or ingot comprises a multitude of parallel defect traces 14 in a depth that defines the split plane 17. The spacing between parallel defect traces 14 is preferably about 100 to about 150 µm , wherein the defect traces 14 are preferably perpendicular to the flat side 13. Further, preferably the defect traces 14 are along one crystallographic plane. The wafer or ingot has a bevel nose or a sharp edge, preferably a sharp edge. Step (i) can be performed with all kinds of crystalline materials as described herein, preferably with silicon or silicon carbide, more preferably with silicon carbide.

In a preferred embodiment of the invention the laser beam interaction effects in a depth of about 110 µm to about 150 µm , preferably about 120 to 130 µm of the wafer or ingot, defects 14a having about 2 µm hight and about 8 µm width and resulting voids 16 of about 10 µm width; wherein the defects 14a and the resulting voids 16 build the defect trace 14; and further parallel defect traces 14, wherein the spacing between parallel defect traces 14 is about 100 µm to 150 µm, wherein the defect traces 14 are perpendicular to the flat side 13, preferably the defect traces 14 are along one crystallographic plane, and preferably the wafer or ingot has no bevel nose but a sharp edge.

Depending on the size of the wafer or ingot, the total void volume of the wafer or ingot to be separated including possible volume of the defects is about 0.5 to 3 mm³, preferably about 0.75 to about 1.5 mm³, more preferably about 0.8 to 1.2 mm³ effected by laser beam interaction in a commercially available wafer or ingot, preferably a Si or SiC wafer or ingot and more preferably a SiC wafer. Excellent results were achieved with SiC prime grade wafers.

The volume of the voids 16 including defects 14a created by the laser beam interaction may be determined by absorption measurements in a BET apparatus.

E.g. for a circular SiC wafer having a diameter of 10 cm a total void volume including the possible volume of the defects 14a is about 0.9 to 1.1 mm³.

One of the fundamental features of this invention is the insertion of a separation medium into at least parts of the voids 16 including the defects 14a that were formed by laser beam interaction.

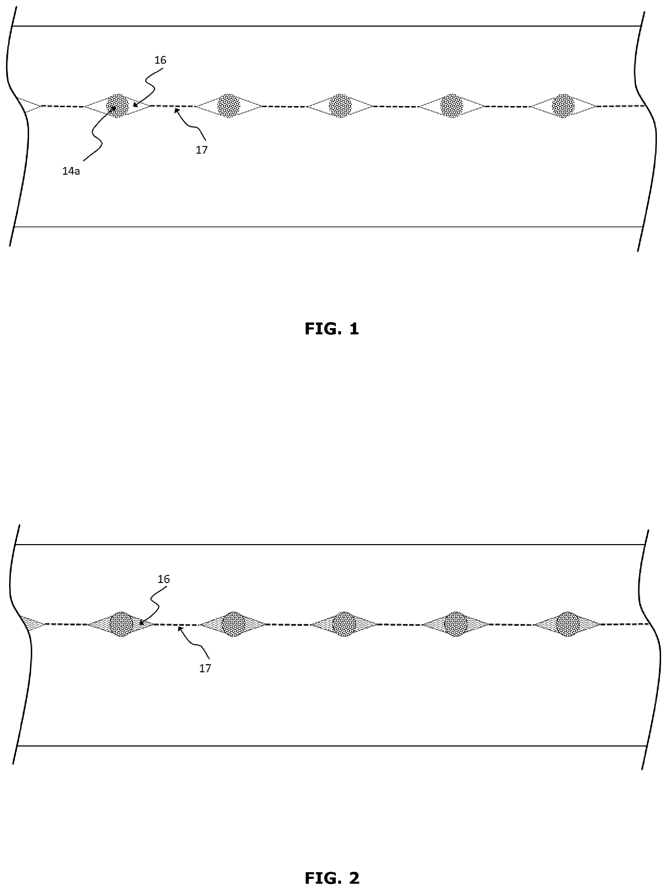

The laser beam interaction causes a spherical defect 14a, wherein one or more spherical defects build a defect trace 14. A multitude of predominantly parallel defect traces defines the designated split plane 17. During the laser beam interaction within the crystalline material, e.g. in a SiC crystalline material, a decomposition reaction to Si and C takes place that leads to spherical defects 14a. In addition, a crack around that laser induced spherical defect occurs as a second order defect that is named in the context of this invention void 16 as shown in Fig. 1 and 2.

Generally, the propagating fracture line 20 propagates within the split plane 17. As shown in Fig. 1 and 2 the propagating fracture line 20 can be in parallel or perpendicular alignment to the defect trace 14.

Surprisingly, it was found that the splitting process can be beneficially performed if the separation of the substrate from the wafer or ingot is effected in such a manner that the propagating fracture line 20 is in perpendicular alignment to the defect trace 14 und the direction of fracture propagation 20b is in predominantly parallel alignment to the defect trace 14.

Therefore, in a preferred embodiment the separation of the substrate from the wafer or ingot is effected in such a manner that the propagating fracture line 20 is in perpendicular alignment to the defect trace 14 und the direction of fracture propagation 20b is in predominantly parallel alignment to the defect trace 14.

In the methods according to the invention the separation medium can be solid, liquid or gaseous. The separation medium is inserted by means of diffusion of a gaseous separation medium into voids 16 including the defects 14a of the crystalline material, by means of condensation of a gaseous separation medium into voids 16 including the defects 14a of the crystalline material and/or by filling a liquid separation medium into the voids 16 including the defects 14a of the crystalline material.

The separation medium can be any chemical compound or composition, gaseous, liquid or solid that can be inserted into the voids 16 including the defects 14a of the defect trace 14.

A solid can be introduced/inserted into the voids 16 as a powder, by condensation, by sublimation and/or by freezing of a respective compound within the voids 16 and defects 14a of the defect trace 14, respectively. The volume change of the separation medium is effected by changing the thermal, aggregate or chemical state of the separation medium, preferably by a temperature change and/or pressure change and/or a chemical reaction. Of course, if a chemical reaction takes place, the separation medium reacts to the respective end-product of the chemical reaction.

In the context of the invention the volume change of the separation medium may be effected by changing the thermal, aggregate or chemical state of the separation medium. The volume change increases mainly the voids 16 and possibly also the defects 14a and/or establishes connections between the voids. In order to achieve a complete and spontaneously split off of the substrate from the wafer or ingot, the separation medium is filled into 50% to 100 % of the voids, preferably 75% to 100%, more preferably 85 to 100%. In order to facilitate a proper filling of the voids of the defect trace 14 the crystalline material wafer or ingot can be evacuated first in order to allow a gaseous, liquid or powder like compound to be inserted into the voids.

In general, as separation medium chemical compounds having a low boiling point are preferred, such as inert gases like noble gases or nitrogen gas. Further, sticky molecules like ammonia, chlorofluorocarbons, water and pyridine can be used. Substances that wet the material of the substrate well exhibit high capillary forces in pores and crevices. High capillary forces in extended, flat pore systems, in turn, create a disruptive effect in the wafer. From the group of hydrocarbons, linear and branched hydrocarbons can be used, like lower alkanes, alkenes and alkynes, preferably linear and branched alkanes, alkenes and alkynes having a chain length of 1 to 10 carbon atoms, more preferably 1 to 8 carbon atoms, and further preferably 1 to 6 carbons atoms; as well as aromatic compounds like benzene or toluene or combinations thereof. Further, alcohols and ketones are suitable as separation medium as well. In particular, the noble gas is selected from the group consisting of neon, argon, krypton and xenon or combinations thereof, preferably argon and krypton and combinations thereof. The most preferred noble gas is argon as single compound or in combination with other noble gases or the inert gas nitrogen.

Preferred hydrocarbons are aliphatic hydrocarbons such as methane, ethane, propane, butane, pentane, hexane, heptane, octane, nonane and decane; preferably hexane (n- and isohexane); methene, ethene, propene, butene, pentene, hexene, heptene, octene, nonene and decene; preferably methene, ethene, propene (n-propene and iso-propene) and butene; methyne, ethyne, propyne, butyne, pentyne, hexyne, heptyne, octyne, nonyne and decyne; preferably methyne, ethyne, propyne (n-propyne and iso-propyne) and butyne.

Preferred alcohols are selected from the group consisting of methanol, ethanol, propanol, in particular n-propanol and tert.-propanol; butanol, pentanol, hexanol (n- and iso-hexanol), heptanol, octanol (n- and iso-octanol), nonanol (n- and iso-nonanol) as well as decanol (n-and iso-decanol) and combinations thereof, preferably n-propanol and tert.-propanol.

Preferred ketones are ketones having 3 to 14 carbon atoms, in particular propanone (acetone), butanone, pentanone, hexanone, heptanone, octanone, nonanone, decanone, undecanone and dodecanone, preferably acteone.

Further, mobile compounds that wet the SiC surface are preferred, such as ammonia, pyridine or acetylacetone.

In addition, oxygen/hydrogen mixtures can be used as separation medium. Depending on the ratio of the compounds - a pure chemical reaction can occur or a chemical reaction in addition to the thermal reaction, wherein the chemical reaction enhances the splitting off. Of course, the energy change effects also the thermal energy influencing the temperature. Suitable ratios of hydrogen oxygen mixtures are 1:1, 2:1, 4:1 und 5:1 atomic ratio (50%, 66%, 80%, 83% H2 volume). The temperature to start the reaction is 400 - 800 °C, preferred higher than 500 °C.

As a suitable chemical separation medium with oxygen functions are acetone peroxide, ozone.

Nitrogen rich compounds, in particular HN3, nitrate esters of polyols, in particular nitroglycerin and nitrogen-free organic compounds, in particular citric acid combined with chlorates and perchlorate or combinations thereof may be used as well.

When a decomposition of the medium is preferred as a volume change suitable media are HN₃, N₂O, O₃, ethylene oxide. These gases are condensed into the wafer voids 16 including the defects 14a at temperatures -200 to 0 °C at 1 bar pressure. Decomposition reactions start by heating the wafer fast to elevated temperatures of 0 - 800 °C. The reactions effect a decomposition into the elements.

A very effective separation medium is water. Water can be inserted into at least parts of the voids 16 and defects 14a as gaseous water vapor or liquid water followed by optionally cooling below the freezing point (0°C). The freezing may detach the wafer by volume expansion. As a second use the frozen or liquid water will expand rapidly when exposing the wafer to a heat source. According to the general gas equation, 1 mol of a chemical compound, i.e. the separation medium, is about 22.4 liter in gas volume at Standard Temperature Pressure (STP). Therefore, the rapid expansion releases energy that split off the crystalline material from inside out. This energy causes additional cracks around the laser-induced defect trace 14 including the voids 16 and initiates or enhances the split off of the crystalline material substrate. Preferably the separation medium is condensed water or frozen water and is expanded to gaseous water vapor.

In another preferred embodiment, the invention relates to a method for separating a substrate from a wafer or ingot comprising the following steps:
(i) forming of defects 14a and resulting voids 16 within the wafer or ingot by means of a laser beam interaction; wherein the defects 14a and resulting voids 16 are arranged in a row to build a defect trace 14, wherein the entire wafer or ingot comprises a multitude of parallel defect traces 14 in a depth that defines the split plane 17; the spacing between parallel defect traces 14 is preferably about 100 to about 150 µm, wherein the defect traces 14 are preferably perpendicular to the flat side 13 and the defect traces 14 are along one crystallographic plane, the wafer or ingot has a sharp edge, depth of about 110 µm to about 150 µm , preferably about 120 to 130 µm of the wafer or ingot, defects 14a having about 2 µm hight and about 8 µm width and resulting voids 16 of about 10 µm width; and optionally further parallel defect traces 14; wherein step (i) can be performed with all kinds of crystalline materials, preferably with silicon or silicon carbide, more preferably with silicon carbide;
(ii) inserting a separation medium into at least parts of the voids 16 including defects 14a; wherein the separation medium is preferably, nitrogen and water; preferably condensed nitrogen and condensed water; the separation medium is filled into 50% to 100 % of the voids, preferably 75% to 100%, more preferably 85 to 100%;
(iii) effecting a volume change of the separation medium within the voids 16 including defects 14a, preferably by means of heating;
(iv) splitting the substrate off the wafer or ingot by means of the volume change of the separation medium.

Optionally this method may comprise the additional step of
(v) effecting the separation of the substrate from the wafer or ingot by a mechanical means.

Depending on the size of the wafer or ingot, the total void volume of the wafer or ingot to be separated including possible volume of the defects is about 0.1 to 3 mm³, preferably about 0.75 to about 1.5 mm³, more preferably about 0.8 to 1.2 mm³ effected by laser beam interaction in a commercially available wafer or ingot, preferably a Si or SiC wafer or ingot and more preferably a SiC wafer. Excellent results were achieved with SiC prime grade wafers.
In this embodiment any additional mechanical means are performed by an adhesive, preferably an adhesive or adhesive tape.

A reverse mechanism is also possible when the separation medium covers the surface of the voids in a manner that a volume compression collapses the remaining crystalline "walls", columns or areas between the voids 16 including defects 14a within the defect trace 14 or neighboring defect traces 14. Both ways of volume change increase the voids and/or establish connections between the voids meaning collapsing the "walls", columns or areas in order to split off the substrate from the ingot or wafer.

This reverse mechanism may be applicable in connection with the use of adhesives and polymers that are able to be inserted into the voids 16 in a liquid or gaseous state and afterwards effect a compression during or after the curing process.

The volume change in the context of this invention is about 2 to about 130.000 % increase or decrease in volume, preferably 2 to 125.000 % of the separation medium within the voids. As an example, if 1 mmol water equal to 18 µl water is used to fill the defect trace within the crystalline material wafer or ingot then 1 mmol water expands to 22.4 ml gaseous water STP which is a 122.000 % volume increase or decrease depending on the volume change direction. The resulting gas pressure in the voids 16 including the neighboring defects 14a before splitting may raise to 500 - 1.000 bar. Preferably condensed water is expanded via a rapid temperature rate of 50 - 800 °C sec-1, preferably 200 - 500 °C sec-1.

In another embodiment of the invention the following steps:
(ii) inserting a separation medium into at least parts of the voids 16 including defects 14a;
(iii) effecting a volume change of the separation medium within the voids 16 including defects 14;
(iv) splitting the substrate off the wafer or ingot by means of the volume change of the separation medium
can be performed two or more times, if necessary. Further, these 3 steps can be performed with different separation mediums having different thermal and or chemical states, different chemical compounds etc. In detail the volume change can be effected by changing the thermal or chemical state alone and/or by changing the thermal and chemical state.

Of course, optionally this method may comprise the additional step of
(v) effecting the separation of the substrate from the wafer or ingot by a mechanical means
in case the substrate is not spontaneously split of the wafer or ingot.

In a preferred embodiment nitrogen is used in this method as first separation medium followed by a repetition of this method by using water as separation medium or vice versa.

In an embodiment of this invention the volume change of the separation medium is effected by heating. Heating can be effected by means of e.g. an oven, calandria, preheated metal block, hotplate, hot air dryer/heat gun, infrared irradiation and/or microwave absorption. Preferably, a preheated metal block or a hot air dryer/heat gun is used in case the separation medium is water or nitrogen.

In one embodiment, when condensed water is used as separation medium, the separation medium is heated rapidly by means of contacting the crystalline material, i.e. the wafer or ingot with a preheated material, preferably a material with high thermal conductivity, more preferably with a preheated metal block, preferably made of metals or other materials with high thermal conductivity, preferably preheated to more than 300 °C.

In general, the volume change may impart stress in at least a portion of the wafer or ingot, such that the cracks around the laser induced defects 14 may expand and initiate fractures or enhances the already existing defects 14a, fractures and voids 16. In order to effect the volume change uniformly throughout the wafer or ingot, it is preferred to perform a degassing step by heating and/or evacuating prior to the insertion of the separation medium.

Suitable pressure ranges for evacuation are about 1x10⁻¹ to about 1x10⁻¹¹ mbar, about 1x10⁻² to about 1x10⁻⁸ mbar, about 1x10⁻³ to about 1x10⁻⁶ mbar, about 1x10⁻⁴ mbar applied in a temperature range of about 0 to about 900 °C, preferably about 100 to about 600 °C, more preferably about 300 to about 500 °C. For evacuation a time frame of typically about 4 to about 8 hours is used. However, shorter or longer time may be used to effect the same result.

In general, suitable temperatures ranges for separating the substrate from the wafer or ingot depending on the used separation medium are from about -272 to about 1400 °C, from about -200 to about 1300 °C, from about 0 to about 1000 °C, from about -200 to about 500 °C and from about -200 to about 300 °C.

Heat treatments can be performed on one side of the crystalline material only, e.g. for a thick crystalline material like an ingot, or on one or both sides for a thinner crystalline material like e.g. for a wafer.

In a preferred embodiment heating of a wafer, preferably a SiC wafer, is performed by means of a hot air dryer/heat gun. For this purpose, a commercially available hot air dryer/heat gun can be used, with a maximum air outlet temperature of about 650 °C and a maximum air volume of 1500 L min-1. The wafer having a DxH of 100 x 0.32 mm and is heated with a distance of about 0.9 m from room temperature (23 °C) to 350 °C within 4 seconds. Within the first second of heating a heating rate of about 200 °C sec-1 is achieved.

Further preferred embodiments of the methods according to this invention comprise a precooling of the crystalline material, the wafer or the ingot to about - 200 °C or temperatures at about -30 °C prior to the above-described heating.

Depending on the size of the wafer, the volume change of the separation medium per time, i.e. the volume change rate of the separation medium within the voids 16 and the defects 14a, as well as the propagation of the cracks around voids 16 and the defects 14a can change. Further, also depending on the shape (circular or angular) of the substrate to be split off, the specific conditions may vary and can be adapted respectively.

In a preferred embodiment, the invention relates to a method for separating a substrate from a wafer or ingot comprises the following steps:
(i) forming of defects 14a and resulting voids 16 within the wafer or ingot by means of a laser beam interaction;
(ii) inserting nitrogen as separation medium into at least parts of the voids 16 including defects 14a; preferably 95% of the voids 16; or
   inserting water as separation medium into at least parts of the voids including defects 14a, preferably 95% of the voids 16 including defects 14a;
(iii) effecting a volume change of the separation medium within the voids 16 including defects 14a;
(iv) splitting the substrate off the wafer or ingot by means of the volume change of the separation medium.

In case that there is no spontaneous split off the substrate from the wafer or ingot, optionally the additional step of
(v) effecting the separation of the substrate from the wafer or ingot by a mechanical means.
is performed.

In order to separate the substrate from the wafer or ingot, the wafer or ingot is fixed to a support e.g. on one side to a fix support 21 and to a flex support 22 on the opposite side of the wafer or ingot. This fixation may be established by means of an adhesive. In order to avoid that the applied adhesive plugs the voids 16 or the cracks at the flat 13 or wafer/ingot edge, an adhesive tape may be used, or the edges of the wafer or ingot are covered with a grease, e.g. paraffin film; in order to avoid entering of the adhesive into the voids 16 including defects 14a and/or cracks which would hamper the splitting off unnecessarily.

In the state of the art, it is known or - at least tried - to split off wafers by means of mechanical forces, mostly with bad results. The used crystalline materials are very brittle and tend to crack. Surprisingly, now it was found that the direction of the splitting off process is very important.

Starting from a commercially available lasered wafer or ingot - and therefore - skipping the first step of the inventive method or forming defects 14a and resulting voids 16 within the wafer or ingot by means of a laser beam interaction (lasering) or performing the lasering as a first step makes no difference.

It was surprisingly found that effecting the separation of the substrate from the wafer or ingot by a mechanical force applied in such a manner that the propagating fracture line 20 is in perpendicular alignment to the defect trace(s) 14 and the direction of fracture propagation 20b is in predominantly parallel alignment to the defect trace(s) 14 is very advantageous. This orientation effects a very easy and smooth separation of the substrate from the wafer and ingot. In most cases an audible crack is a reliable indicator for the "self-split off'.

Therefore, in another embodiment the invention relates to a method for separating a substrate from a wafer or ingot comprising the following steps:
(i) forming of defects 14a and resulting voids 16 within the wafer or ingot by means of a laser beam interaction;
(vi) effecting separation of the substrate from the wafer or ingot by a mechanical force applied in such a manner that the propagating fracture line 20 is in perpendicular alignment to the defect trace(s) 14 and the direction of fracture propagation 20b is in predominantly parallel alignment to the defect trace(s) 14.

In this embodiment the mechanical forces that are necessary to split of the substrate from the ingot or wafer can be applied in such a manner that the wafer or ingot is fixed to a fix support 21 on one side of the wafer or ingot, and to a flex support 22 on the opposite side of the wafer or ingot; preferably by an adhesive. For small wafers, e.g. having about 0.5 to about 10 cm diameter or edge length, a commercially available adhesive tape can be used as flex support 22. Combinations of adhesives can be used for optimization of the requirements of the fix support 21 and flex support 22. Especially, the flex support 22 used flexible adhesives like tapes and the fix support 21 uses polymerization adhesives with high adhesion. This fixation may be established by means of an adhesive, preferably by a low viscosity adhesive; e.g. a commercially available one-component adhesives, such as methacrylates, or 2-component adhesives, such as cyanoacrylates.

Even if this method does not use a separation medium to separate the substrate from the wafer or ingot, also an important feature is the step of
(i) forming of defects 14a and resulting voids 16 within the wafer or ingot by means of a laser beam interaction.
The goal of this step is to create a kind of open porosity in a split plane 17 of the wafer or ingot to be separated that is also preferably open to the outside along the edge.

The defects 14a and resulting voids 16 are arranged in a row or a specific pattern to build a defect trace 14. At least one defect trace, preferably more than one defect trace 14 are effected into the wafer or ingot. More preferably, the entire wafer or ingot comprises a multitude of parallel defect traces 14 in a depth that defines the split plane 17. The spacing between parallel defect traces 14 is preferably about 100 to about 150 µm, wherein the defect traces 14 are preferably perpendicular to the flat side 13. Further, preferably the defect traces 14 are along one crystallographic plane. The wafer or ingot has a bevel nose or a sharp edge, preferably a sharp edge. Step (i) can be performed with all kinds of crystalline materials as described herein, preferably with silicon or silicon carbide, more preferably with silicon carbide.

In a preferred embodiment of the invention the laser beam interaction effects in a depth of about 110 µm to about 150 µm, preferably about 120 to 130 µm of the wafer or ingot, defects 14a having about 2 µm hight and about 8 µm width and resulting voids 16 of about 10 µm width; wherein the defects 14a and the resulting voids 16 build the defect trace 14; and

further parallel defect traces 14, wherein the spacing between parallel defect traces 14 is about 100 µm to 150 µm, wherein the defect traces 14 are perpendicular to the flat side 13, preferably the defect traces 14 are along one crystallographic plane, and preferably the wafer or ingot has no bevel nose but a sharp edge.

Even if this method can also be performed with all materials described herein, in a preferred embodiment, this method is performed with crystalline material selected from silcon and silicon carbide, preferably silicon carbide.

In another embodiment of this invention the split off of the substrate from the wafer or ingot may successfully effected regardless of the direction of the defect trace 14 und the direction of the fracture propagation 20b to each other by means of the following method.

In a further embodiment the invention relates to a method for separating a substrate from a wafer or ingot comprising the following steps:
(i) forming of defects 14a and resulting voids 16 within the wafer or ingot by means of a laser beam interaction;
(vii) effecting separation of the substrate from the wafer or ingot by fixing the wafer or ingot between a convex support 42 and a concave support 41 of a spherical calotte;
(viii) moving the convex support 42 and the concave support 41 of the calotte into each other while allowing the wafer or ingot to adapt to the shape of the calotte;
(ix) cooling the concave support 41 of the calotte and at the same time heating the convex support 42 or vice versa.

Also in this method is the step of
(i) forming of defects 14a and resulting voids 16 within the wafer or ingot by means of a laser beam interaction.
is performed as described in the other methods of this invention.

In a preferred embodiment of this method, the defects 14a and resulting voids 16 are arranged in a row to build a defect trace 14. Preferably, the entire wafer or ingot comprises a multitude of parallel defect traces 14 in a depth that defines the split plane 17. The spacing between parallel defect traces 14 is preferably about 100 to about 150 µm, wherein the defect traces 14 are preferably perpendicular to the flat side 13. Further, preferably the defect traces 14 are along one crystallographic plane. The wafer or ingot has a bevel nose or a sharp edge, preferably a sharp edge. Step (i) can be performed with all kinds of crystalline materials as described herein, preferably with silicon or silicon carbide, more preferably with silicon carbide. Further, the laser beam interaction effects in a depth of about 110 µm to about 150 µm, preferably about 120 to 130 µm of the wafer or ingot, defects 14a having about 2 µm hight and about 8 µm width and resulting voids 16 of about 10 µm width; wherein the defects 14a and the resulting voids 16 build the defect trace 14 and further parallel defect traces 14, wherein the spacing between parallel defect traces 14 is about 100 µm to 150 µm, wherein the defect traces 14 are perpendicular to the flat side 13, and preferably the defect traces 14 are along one crystallographic plane, and preferably the wafer or ingot has no bevel nose but a sharp edge.

In a further preferred embodiment, the entire wafer or ingot comprises a further multitude of parallel defect traces 14 in a depth that defines the split plane 17 that is perpendicular arranged to the already existing multitude of parallel defect traces 14 in the same depth, i.e. the already existing split plane.

Even if this method can also be performed with all materials described herein, in a preferred embodiment, this method is performed with crystalline material selected from silicon and silicon carbide, preferably silicon carbide.

In another preferred embodiment a lubricant is applied to the surface of at least one support, i.e. the concave support 41 of the calotte or the convex support 42 or both supports. As lubricant e.g. a boron nitride may be used, preferably a nanoscale hexagonal boron nitride.

In another embodiment an adhesive is applied to the surface of at least one support, i.e. the concave support 41 of the calotte or the convex support 42 or both supports. As adhesives e.g. a commercially available low viscosity adhesive may be used, e.g. a methacrylate adhesive.

In principle, the two supports of the calotte, the concave support 41 and the convex support 42 may be simply put together without any twist. This alone leads to a pretension of the wafer or ingot when it adapts to the shape of the support. In this respect, high quality wafer take more flex than engineering grade wafer. However, the pretension can be further enhanced by twisting one of the supports while bringing the two supports together. Of course, dependent on the use of an adhesive or a lubricant the pretension can be further enhanced, respectively. Due to this pretension the orientation of the defect trace is irrelevant and therefore, using a hot and a cold support only in combination with a lubricant leads to a "self-split" off spontaneously.

In a further embodiment the invention relates to a method for separating a substrate from a wafer or ingot comprising the following steps:
(i) forming of defects 14a and resulting voids 16 within the wafer or ingot by means of a laser beam interaction;
(vii) effecting separation of the substrate from the wafer or ingot by fixing the wafer or ingot between a convex support 42 and a concave support 41 of a spherical calotte; whereas an adhesive is applied to the surface of at least one support;
(viii) moving the convex support 42 and the concave support 41 of the calotte into each other while allowing the wafer or ingot to adapt to the shape of the calotte;
(ix) cooling the concave support 41 of the calotte and at the same time heating the convex support 42 or vice versa and
(x) twisting at least one support against the other support.
For step (i) the same applies as already described earlier.

In this embodiment, an adhesive is applied to the surface of at least one support, i.e. the concave support 41 of the calotte or the convex support 42 or both supports. As adhesives e.g. a commercially available low viscosity adhesive may be used, e.g. a methacrylate adhesive.

In all methods using the spherical calotte support, in a preferred embodiment of this method the spherical calotte has a about 0.4 mm to about 4 mm elevation. High quality wafer take more flex than engineering grade wafer. It turned out that this elevation "a" of the spherical calotte being about 0.4 mm to about 4 mm is enough to facilitate a spontaneous complete separation but on the other hand the curvature of the wafer is enough in order to avoid wafer breakage/crack.

In case the split off does not happen spontaneously, then it is recommended to use the adhesive and performed step (x), the twisting step.

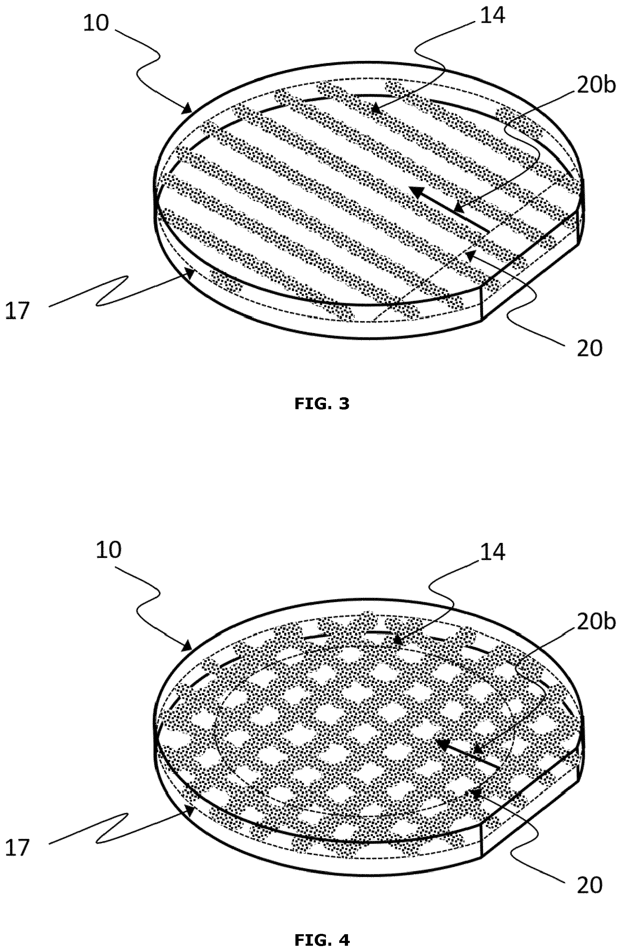

All methods using this calotte-shaped form or "mold" is highly efficient and far superior to a similar method using a cone-shaped or a bridge-shaped calotte equivalent. This may be based on the circular propagating fracture line 20 as shown in Fig. 4.

In all of these calotte-shaped methods the wafer or ingot is laser treated as in the other methods meaning the defects 14a and resulting voids 16 are arranged in a row to build a defect trace 14. Preferably, the entire wafer or ingot comprises a multitude of parallel defect traces 14 in a depth that defines the split plane 17. The spacing between parallel defect traces 14 is preferably about 100 to about 150 µm, wherein the defect traces 14 are preferably perpendicular to the flat side 13. Further, preferably the defect traces 14 are along one crystallographic plane. The wafer or ingot has a bevel nose or a sharp edge, preferably a sharp edge. Step (i) can be performed with all kinds of crystalline materials as described herein, preferably with silicon or silicon carbide, more preferably with silicon carbide. Further, the laser beam interaction effects in a depth of about 110 µm to about 150 µm, preferably about 120 to 130 µm of the wafer or ingot, defects 14a having about 2 µm hight and about 8 µm width and resulting voids 16 of about 10 µm width; wherein the defects 14a and the resulting voids 16 build the defect trace 14 and further parallel defect traces 14, wherein the spacing between parallel defect traces 14 is about 100 µm to 150 µm, wherein the defect traces 14 are perpendicular to the flat side 13, and preferably the defect traces 14 are along one crystallographic plane, and preferably the wafer or ingot has no bevel nose but a sharp edge.

In a further preferred embodiment, the entire wafer or ingot comprises a further multitude of parallel defect traces 14 in a depth that defines the split plane 17 that is perpendicular arranged to the already existing multitude of parallel defect traces 14 in the same depth, i.e. the already existing split plane. This laser pattern is shown in Fig. 4. In all these methods using calotte-shaped forms, the wafers or ingots preferably having further parallel defect traces 14 building a defect trace grid as shown in Fig. 4 being perpendicular to the defect traces 14 as shown in Fig. 3. This defect trace grid as shown in Fig. 4 is ideal for a circular propagating fracture line as shown also in Fig. 4.

Even if this method can also be performed with all materials described herein, in a preferred embodiment, this method is performed with crystalline material selected from silicon and silicon carbide, preferably silicon carbide.

The above-described method step (v) that is used in case that there is no spontaneous split off the substrate from the wafer or ingot in the above descripted methods i.e.
(v) effecting the separation of the substrate from the wafer or ingot by a mechanical means.
can be performed by using is following apparatus named "detaching device I".

An apparatus for separating a substrate from a wafer or ingot comprising
a piston 25;
a fix support 21 having a mount of fix support 21a and an adhesive area I;
a flex support 22 having a piston application area and an adhesive area II; wherein the adhesive area I and II are located opposite to each other;
the piston 25 is arranged in such manner that during operation the piston force is applied to the piston application area; and
the wafer or ingot to be separated is affixable between the fix support 21 and the flex support 22 in the respective adhesive areas I and II.

In a further embodiment, the apparatus may have a specific area within the flex support, a "modification of flex support" 24. This modification of flex support 24 is a special embodiment of the flex support 22, wherein within this specific area within the flex support 22 the material is thinner than in the other areas of the flex support 22. This thinner area enhances the bending capabilities of the flex support 22 during operation when the piston pushes the flex support. The thinner material is responsible for the modus of peeling for the initiation of the fracture line and the other area causes split conditions.

In operation mode, the upper and downside of the wafer or ingot is fixed to one of the support, the flex support 22 and the fix support 21 on both opposing sides. Preferably, the intended thicker part of the wafer or ingot is fixed to the fix support 21 and the substrate to be separated is fixed to the flex support 22. For the fixation of the wafer or ingot to the fix support 21 and flex support 22 an adhesive may be used. As adhesive a commercially available adhesive, preferably, a low viscosity adhesive for a self-regulating constant adhesive gap, e.g. a commercially available one-component adhesives, such as a methacrylate adhesive, or a 2-component adhesive, such as cyanoacrylates may be used. In a preferred embodiment, the wafer side that is fixed to the fix support 21 is fixed by means of a low viscosity adhesive for a self-regulating constant adhesive gap, e.g. a methacrylate adhesive or a cyanoacrylate adhesive and the wafer side fixed to the flex support 22 is fixed by means of an adhesive tape. Preferably the fix support 21 and flex support 22 are roughen on the area of adhesive I and II by means of a sandpaper followed by degreasing with a solvent e.g. acetone; in order to improve fixation.

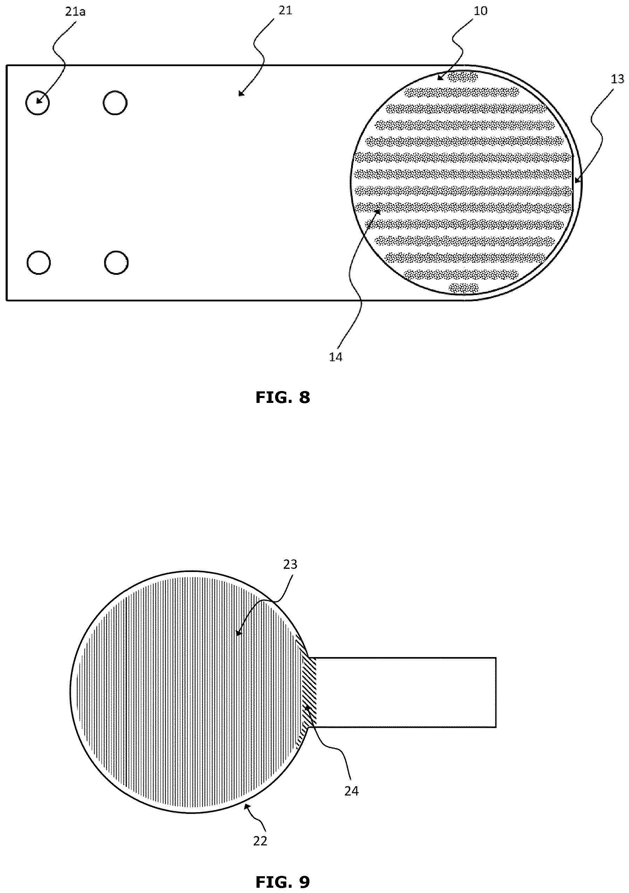

Fig. 8 shows a typical fix support 21 having a mount of fix support 21a dealing with fixation of the fix support 21 to a holder, an upright housing, a leverage, a rack or a wall etc., preferably in a holder of a universal testing machine The wafer is shown as a circular area 10 which is identical with the area of adhesive 23 on the fix support.

Fig. 9 shows a typical flex support 22 having an area of adhesive 23. In this preferred embodiment the optional area of modification of flex support 24 is shown as area between the circular shaped area on which the wafer is fixed and the area on which the piston 25 pushes during operation.

The fix support is immobile and fixed with the mount of fix support 21a to a holder, an upright housing, a leverage, a rack or a wall etc.; preferably in a holder of a universal testing machine; wherein during operation a mechanical force ranging from about 2.2 to about 2.8 N for a 16x16 mm wafer, from about 3.2 to about 6 N for a 35x35 mm wafer and about 28 to about 90 N for a 100x100 mm wafer can be exerted on the flex support 22 to create stress on one side of the wafer. The mechanical stress on one side of the wafer imparts a bending moment in at least a portion of the wafer or ingot. The bending moment is transmitted to the defect traces 14 and initiates the fracture.

When fracturing the crystalline material, i.e. effecting the separation of the substrate from the wafer or ingot by a mechanical force, the mechanical force is applied in such a manner that the propagating fracture line 20 is in perpendicular alignment to the defect trace(s) 14 and the direction of fracture propagation 20b is in predominantly parallel alignment to the defect trace(s) 14. Depending on the size of the crystalline material and/or the flexible support and the development of the fracture, the flexible support may be readjusted in order to avoid a too strong bending moment in one place and thus a breakage of the wafer or ingot to be separated.

After a complete fracture, the two parts of the crystalline material remain connected to the supports and may be detached from them so that one or both parts can be processed further. In detail, the substrate of the wafer or ingot remains on the flex support and the rest of the wafer or ingot remains on the fix support for a further separation cycle or further treatment. Detachment can be performed with a respective solvent that solve the used adhesive and effect detachment. Preferably, the used low viscosity adhesive, e.g. a methacrylate adhesive or a cyanoacrylate adhesive or the adhesive tape is removed with acetone. Suitable

In a further embodiment, a movable pressure device can be used as piston, which can maintain constant pressure on the flex support, i.e. exerting pressure on the flex support 22 so that it is parallel to the fix support. Suitable pressure ranges are from about 10 to 200 N, preferably from about 15 to about 100 N, and more preferably from about 10 N to about 50 N).

In another embodiment, the movable pressure device acting as a piston 25 or the piston 25 of the apparatus may be in front of the crystalline material and not yet have any direct pressure on it. The flexible support may bend under tensile stress. The movable pressure device moves under constant pressure, preferably in the direction of the upwardly bend support and preferably by path control of guide rails in a universal testing machine.

In another embodiment, independent whether a movable pressure device with a piston 25 or a fixed pressure device having the piston 25, the piston 25 presses at a distance of about 40 to 80 mm, preferably 50 to 70 mm, more preferably 60 mm from the flat 13 vertically and centrally on the narrow part opposite to the semi circular part comprising the fixed wafer or ingot of the flex support 22 (traverse speed about 2 mm min-1, force sensor about 180 to 220 N). After about 1 to 3 mm movement of the piston the pressure drops from about 25 N to about 20 N. The break initiation and progress is audible and stops at about 20 mm. The fracture line progresses jerkily as the piston moves further and at about 4 mm movement of the piston the wafer or ingot part that is fixed to the flex support 22 separates completely. The result is two parts the substrate and the remaining wafer or ingot. The split wafers are removed from the support with acetone.

The above-described method step (v) that is used in case that there is no spontaneous split off the substrate from the wafer or ingot in the above descripted methods i.e.
(v) effecting the separation of the substrate from the wafer or ingot by a mechanical means.
can be performed by using is following apparatus named "detaching device II":

The invention further relates to an apparatus for separating a substrate from a wafer or ingot comprising
a fix support (21), preferably on which a wafer or ingot is locally affixable upside;
being connected with a movable table with precision guidance having a guide rail (29);
a flex support 22 on which a wafer or ingot is fixable underneath that may be kept under tension by pulling upwards bound in moving direction;
a rocking support (27) between the roll and the flex support (22); and
a pressure roller with cardan suspension (28) located perpendicular on the surface of the fix support (21) and having an axis perpendicular to the moving direction of the guide rail (29)
a frame connecting the fix and flex support with the pressure roller with cardon suspension (28).

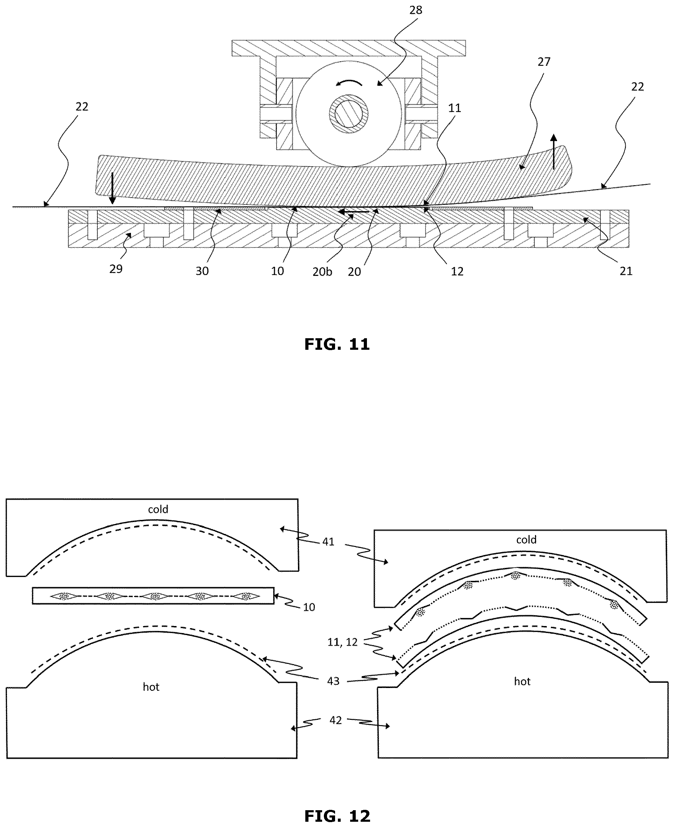

In this embodiment the flex support 22 on which a wafer or ingot is fixable underneath may be kept under tension by pulling upwards bound in moving direction. This means that one could pull the flex support by hand or by a pulling device upwards bound in moving direction in order to provide a tension on the flex support 22. Alternatively, a pneumatic tension application may be used being capable to pull flex support (not shown in Fig. 11) upwards bound in moving direction. The flex support may be pulled with a force of from about 2 to about 100 N upwards bound in moving direction. The pneumatic tension application may further have a height adjustment from in plane to 100 mm height to facilitate a bended flex support under the rocking support.

In a preferred embodiment the fix support 21 comprises an integrated mask 30, i.e. an indentation of the fix support that incorporates the wafer 10 to provide a plain surface on the top of the fix support 21. This plain surface reduces the pressure of the roller on the wafer and therefore makes this splitting off method much less susceptible for wafer cracking.

In another preferred embodiment an apparatus for separating a substrate from a wafer or ingot comprising
a fix support 21 having an elevated area on which a wafer or ingot is locally affixable upside;
being connected with a movable table with precision guidance having a guide rail 29;
a flex support 22 on which a wafer or ingot is fixable underneath that may be kept under tension by pulling upwards bound in moving direction, preferably by a pneumatic tension application;
a rocking support 27 between the roll and the flex support 22; and
a pressure roller with cardan suspension 28 located perpendicular on the surface of the fix support 21 and having an axis perpendicular to the moving direction of the guide rail 29
a frame connecting the fix and flex support with the pressure roller with cardon suspension 28.

In this embodiment of the apparatus the elevated area of the fix support enables possible excess of adhesive to flow away as well as simplifies the use of an additional mask that is used for adjusting the plane for the rocking support 27. When a mask is used, the fix support 21 comprises an integrated mask 30, i.e. an indentation of the fix support that incorporates the wafer 10 to provide a plain surface on the top of the fix support 21. This plain surface reduces the pressure of the roller on the wafer and therefore makes this splitting off method much less susceptible for wafer cracking. In addition, due to the flexibility of the flex support 22, only a short bending zone of the wafer or ingot is needed from the start to the end during operation; this short bending zone is in contact with the rocking support and the parts free of contact of the flex support are planar. Since this apparatus only needs to bend a fraction of the wafer or ingot in the separation process during operation, so less stress is applied to the wafer or ingot and therefore, less breakage occurs compared to apparatuses and methods that bend the complete flex support.

The pneumatic tension application (not shown in Fig. 11) pulls at the free end of the flex support with a force of about 2 to 100 N, preferably 15 to 85 N upwards bound in moving direction and having preferably a height adjustment from in plane to about 100 mm to facilitate a bended flex support 22 under the rocking support 29. As movable table with precision guidance having a guide rail 29 an universal test machine for path and force control of the fix support on the guide rails 29 may be used. This movable table with precision guidance having a guide rail 29 or a universal test machine provides the force to roll the roller roll of the pressure roller with cardan suspension 28. During operation, the guide rail 29 moves linearly under the roll, the rocking support rolls on the flex support or mask, a bending zone inside the flex support travels from the flat 13 to the opposite side of the wafer or ingot. The pressure roller with cardan suspension 28 moves perpendicular to the plane of the guide line for pressing the rocking support 27 onto the flex support and the mask, respectively. The roller direction is anticlockwise along the guide line that is parallel to the direction of propagation 20b being identical with the moving direction. Typically, the pressure roller with cardan suspension is pressed by pneumatic forces of about 30 to 1000 N, preferably down to the rocking support 27.

In operation, at the beginning of the separation process of the wafer or ingot, the rocking support 27 facilitates a peel stress for initiating a propagation fracture line 20 by a radius of 0.75 m. After about 0.5 to about 10 mm of rocking the modus of propagation changes to gap or split stress due to a much larger radius of about 2 m. The rocking support 27 is rolling on the flex support 22 and if present on the mask in order to facilitate separation of the substrate from the wafer or ingot. The advantage of a constant height rocking support different radii and unwinding lengths can be produced, making it easy to adjust to different wafer or ingot properties.

In a further preferred embodiment the elevation area of the fix support 21 is about DxH about 100 x about 3 mm and the fix support 21 and the flex support 22 are made of AlMg4,5Mn CNC-manufactured, preferably having dimensions of about 250 x 140 x 10 mm.

In embodiments using a mask 30, the mask 30 is preferably made of AlMg4,5Mn being an indentation of the fix support that incorporates the wafer 10 to provide a plain surface on the top of the fix support 21 on which the rocking support rolls; in case of the plane of rocking is higher than the surface of the flex support, no forces are applied onto the wafer. Dimensions of the mask are preferably about 150 x about 140 with variable height, e.g. about 3 mm.

In addition, Fig. 11 shows the direction of the pressure roller moving anticlockwise during operation and at the same time the direction of fracture propagation 20b moves from right to left. The roller pressure is focused on one line on the wafer, i.e. on the propagating fracture line 20 that is perpendicular to the direction of fracture propagation. On the right side of the propagating fracture line 20 the split wafer flexed 11 and the split wafer fixed 12 are shown.

The advantage of using this apparatus having the rocking support and the pressure roller (Detaching device II) in comparison to apparatus using a piston (Detaching device I) is that the pressure of the roll is only applied to a line on the wafer surface, whereas using the apparatus having the piston, the whole surface of the flex support including the split wafer is bent. This means that detaching device II reduces significantly the danger of breaking the wafer in comparison to the apparatus using the piston and both apparatuses are superior than other apparatuses and methods described in the prior art that dominantly apply gap stress to the wafer or ingot instead of peel stress as performed in the present invention. Due to this significantly reduced stress applied to the wafer or ingot, the danger of breaking the wafer is significantly reduced.

The before mentioned methods of separating a substrate from a wafer or ingot using a spherical calotte supports is preferably performed in the following apparatus:
An apparatus for separating a substrate from a wafer or ingot comprising
a convex support 42 and a concave support 41 of a spherical calotte, wherein
the wafer or ingot to be separated is affixable between the convex support 42 and concave support 41;
the convex support 42 and concave support 41 of the calotte are moveable into each other while allowing the wafer or ingot to adapt to the shape of the calotte; and
the concave support 41 of the calotte is coolable and at the same time the convex support 42 is heatable or vice versa.

In a preferred embodiment of the apparatus the spherical calotte has a about 0.4 mm to about 4 mm elevation. High quality wafer takes more flex than engineering grade wafer. It turned out that this elevation "a" of about 0.4 mm to about 4 mm is enough to facilitate a spontaneous complete separation but on the other hand the curvature of the wafer is enough in order to avoid wafer or ingot breakage.

From Fig. 12, it can be seen that the dimensions of the spherical calotte are a little bit larger than the dimensions of the wafer or ingot to be separated in order to facilitate the respective pretension being the prerequisite of the spontaneous split off.

The accompanying drawings and figures incorporated in and forming a part of this invention illustrate several aspects of the disclosure, and together with the description serve to explain the principles of the disclosure.

Preferred embodiments of this invention are described herein. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present disclosure. As used herein, the term "and/or" includes any and all combinations of one or more of the associated listed items.

It will be understood that when an element such as a layer, region, or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. Likewise, it will be understood that when an element such as a layer, region, or substrate is referred to as being "over" or extending "over" another element, it can be directly over or extend directly over the other element or intervening elements may also be present. In contrast, when an element is referred to as being "directly over" or extending "directly over" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

Relative terms such as "below" or "above" or "upper" or "lower" or "horizontal" or "vertical" or "parallel" or "perpendicular" may be used herein to describe a relationship of one element, layer, or region to another element, layer, or region as illustrated in the Figures. It will be understood that these terms and those discussed are intended to encompass different orientations of the device in addition to the orientation depicted in the figures.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including" when used herein specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this disclosure belongs. It will be further understood that terms used herein should be interpreted as having a meaning that is consistent with their meaning in the context of this specification and the relevant art and will not be interpreted in an idealized or overly formal sense unless expressly so defined herein.

The invention is not restricted to the exemplary embodiments shown in the figures - not even with regard to functional features. The previous description as well as the following description contain numerous features, some of which are summarized in several. These features, as well as all the other features disclosed above and in the following description, will, however, also be considered individually by the person skilled in the art and put together to form useful further combinations. In particular, all of the features mentioned can be combined individually and in any suitable combination with the method and apparatus according to the independent claims.

### Brief Description of Drawings

FIG. 1 is a cross-section schematic perpendicularly view of a formation of a defect trace in a crystalline material, e.g. a wafer; showing a defect 14a including void(s) 16 and split plane 17.
FIG. 2 is a cross-section schematic perpendicularly view of a formation of defect trace in a crystalline material, e.g. a wafer; showing filled defects including void(s) 16 filled with a separation medium including a split plane 17.
Fig. 3 is a perspective view schematic of a crystalline material, e.g. a wafer 10; including defect trace 14, split plane 17, propagating fracture line 20 and direction of fracture propagation 20b.
Fig. 4 is a perspective view schematic of a crystalline material, e.g. a wafer 10; including defect trace 14, split plane 17, propagating fracture line 20 and direction of fracture propagation 20b. In comparison to Fig. 3, this wafer has two defect traces 14 meaning the defect traces as shown in Fig. 3 as well as additional defect traces perpendicular thereto. This kind of laser pattern works preferably very well with the calotte apparatus.

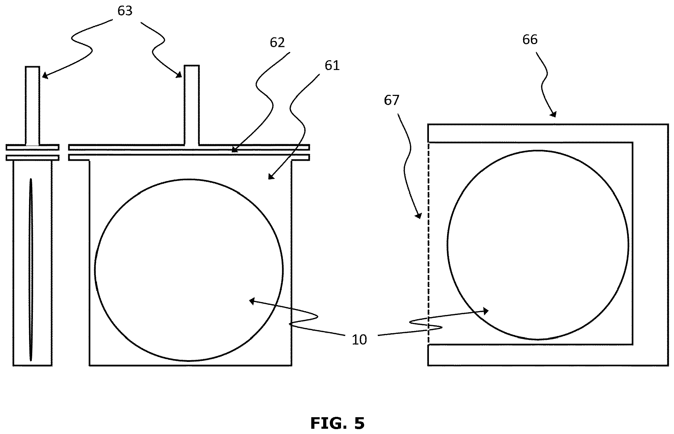

FIG. 5 is a side cross-sectional schematic view of a slit measuring cell 61 (left side) which is connected onto a static, commercial BET measuring device via a measuring tube 63, including wafer 10 and flask 62, and a side cross-sectional schematic view of a heated metal buck with slit 66, including wafer 10 and slit 67.

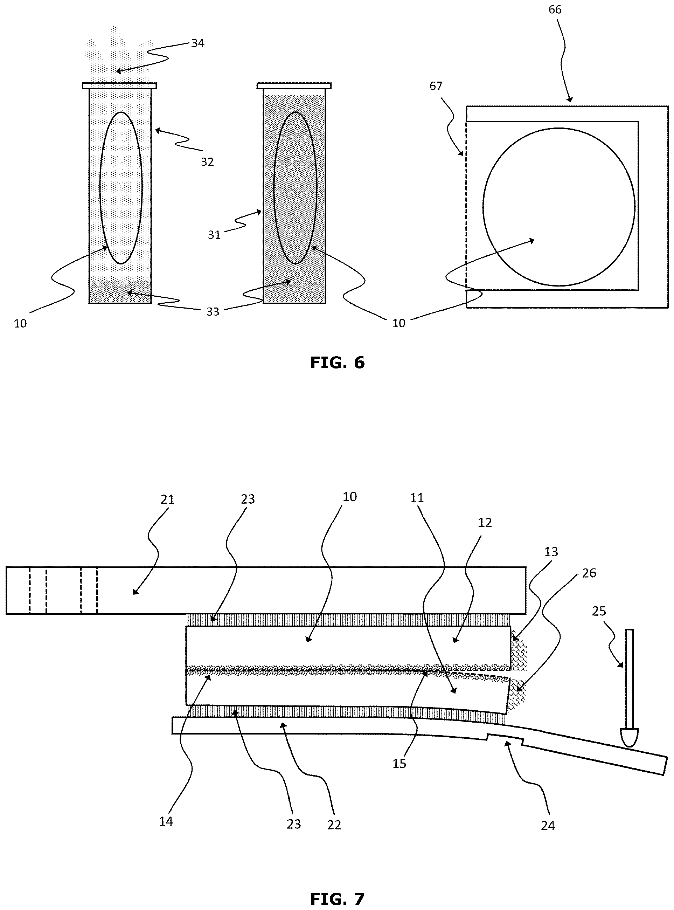

FIG. 6 is a side cross-sectional schematic view of a setup for effecting a temperature change. A liquid bath 31 filled with cooling liquid 33, including wafer 10, a vapor bath 32 (left side), vapor 34 and wafer 10, and a heated metal buck with slit 66 (right side), including wafer 10 and slit 67.
FIG. 7 is a side cross-schematic view of an apparatus "Detaching Device I" comprising a fixed wafer including the fix support 21 and adhesive 23 joined to a crystalline material substrate represented by wafer 10 having defect traces 14 and showing fracture propagation 15. The wafer 10 is joined to a flex support 22 having a modification of flex support 24, via an adhesive 23; a flat 13 and an anti-adhesive 26, including a piston 25. The area of the already split wafer is shown as split wafer 12, fixed and 11 split wafer, flexed.
Fig. 8 shows a top view schematic of a fix support 21 that can be used for an apparatus according to "Detaching device I" having a mount of fix support 21a; comprising a wafer 10 being joined to the fix support having a flat 13 and defect trace 14.
Fig. 9 shows a top view schematic of a flex support 22 having an area of modification of flex support 24 that can be used for an apparatus according to "Detaching device I". The area of adhesive 23 is shown as lengthwise-striped area.

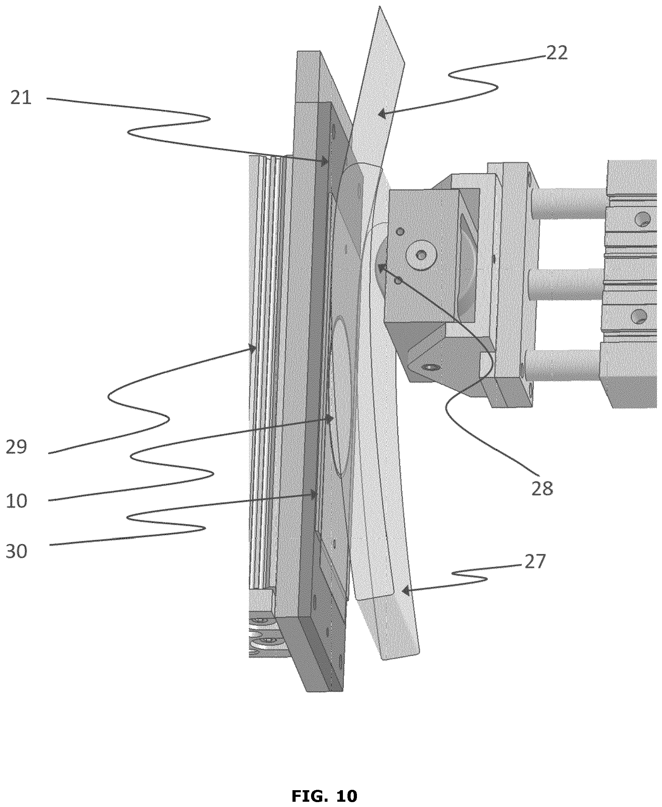

FIG. 10 shows an apparatus according to "Detaching Device II" having a movable table with precision guidance and guide rail 29, a fix support 21, flex support 22, pressure roller with cardan suspension 28 and a rocking support 27. Further, Fig. 10 shows a preferred embodiment having a fix support 21 with integrated mask 30, i.e. an indentation of the fix support that incorporates the wafer 10 to provide a plain surface on the top of the fix support 21. This plain surface reduces the pressure of the roller on the wafer and therefore makes this splitting method much less susceptible for wafer cracking.
FIG. 11 shows a side cross-sectional schematic view of an apparatus according to "Detaching Device II" having a movable table with precision guidance and guide rail 29, a fix support 21, flex support 22 showing right and left end, pressure roller with cardan suspension 28 and a rocking support 27. Further, Fig. 11 shows also the preferred embodiment having a fix support 21 with integrated mask 30, i.e. an indentation of the fix support that incorporates the wafer 10 to provide a plain surface on the top of the fix support 21. This plain surface reduces the pressure of the roller on the wafer and therefore makes this splitting method much less susceptible for wafer cracking. In addition, Fig. 11 shows the direction of the pressure roller moving anticlockwise during operation and at the same time the direction of fracture propagation 20b moves from right to left. The roller pressure is focused on one line on the wafer, i.e. on the propagating fracture line 20 that is perpendicular to the direction of fracture propagation. On the right side of the propagating fracture line 20 the split wafer flexed 11 and the split wafer fixed 12 are shown.
FIG. 12 is a side cross-schematic view of an apparatus having a convex support 42 and a concave support 41 of a spherical calotte. In the shown preferred embodiment, the convex support 42 is hot and the concave support 41 is cold. Further a wafer 10 is shown as well as a lubricant 43 applied on the concave and convex surface of the respective parts of the calotte. On the left side the wafer is shown at the beginning, whereas the right side of Fig. 12 shows the already split wafer.

### List of reference signs:

- 10: wafer
- 11: split wafer flixed
- 12: split wafer flexed
- 13: flat
- 14: defect trace
- 14a: defect
- 15: fracture propagation
- 16: void(s)
- 17: split plane
- 20: propagating fracture line
- 20b: direction of fracture propagation
- 21: fix support
- 21a: mount of fix support
- 22: flex support
- 23: adhesive / area of adhesive
- 24: modification of flex support
- 25: piston
- 26: anti-adhesive
- 27: rocking support
- 28: pressure roller with cardan suspension
- 29: guide rail
- 30: mask
- 31: liquid bath
- 32: vapor bath
- 33: liquid
- 34: vapor
- 41: concave support
- 42: convex support
- 43: lubricant
- 61: slit measuring cell
- 62: flask
- 63: connection tube
- 66: heated metal buck with slit
- 67: slit

### EXAMPLES

### a) Laser treatment

The insertion of the defects 14a into a wafer or ingot by a laser beam can be performed as follows. An open porosity, i.e. the defect traces 14 in the split plane 17 is created by laser beam interaction, preferably a Ytterbium laser; that is also open to the outside along the edge. A total pore volume, i.e. void volume of about 0.5 to 3 mm3, preferably 0.75 to 1.5 mm3 is created. In a commercially available SiC prime grade wafer D = 100 mm, preferably 1 mm3 void volume, 4H, 4° by these parameters:
A) Ytterbium laser,
   - λ = 1060nm
   - 4ns Pulse length
   - 12 µJ total pulse energy
   - 12 kHz frequency
   - 5 µm x pitch
   - 20x objective with NA =0.40
   - 120 µm focused, y pitch (focus depth inside SiC)
   - 150 µm depth of resulting decomposition volume or defect 14a of roughly 5 µm diameter
B) application on a CNC controlled chuck:
   - - 100 - 150 µm spacing between parallel laser traces
   - - laser traces are perpendicular to flat side
   - - laser traces along one crystallographic plane, not perpendicular to plane steps
   - - operation of chuck I): laser traces start from opposite of flat and end on flat side
   - - operation of chuck II): laser traces in both x directions, the traces meander

### b) Heating of crystalline material

The following heating options can be performed:

### (i) hot air dryer/heat gun

For this purpose, a Leistner VULCAN SYSTEM 10 kW is used, with a max. air outlet temperature of 650 °C and a max. air volume of 1500 I min-1. Placing a wafer DxH of 100 x 0.32 mm between two switched on VULCAN SYSTEM with a distance of 0,9 m a heating from room temperature 23 °C to 350 °C is achieved in the wafer after 4 sec. Within the first second a heating rate of 200 °C sec-1 is achieved; Temperature measurement was performed by an infrared thermometer.

### (ii) Infrared irradiation

Alternatively, irradiation with infrared light may be performed exploiting the SiC absorption band at about 770 - 810 cm-1. For this purpose, Heraeus Goldene 8 twin-tube irradiators are used with the following characteristics: 150 - 200 W/cm, typical emitted wavelength 1.0 - 2.0 µm, area power 200 kW/m2 and a response time of 1 sec. Placing a wafer DxH of 100 x 0.32 mm between two switched on Golden 8 with a distance of 0,6 m a heating from room temperature 23 °C to 760 °C is achieved in the wafer after 10 sec. Within the first second a heating rate of 600 °C sec-1 is achieved. 90 % of the end temperature (ca. 675 °C) is reached after t90 = 3.5 sec.

### (iii) Microwave absorption

The dielectric properties of SiC are suitable for microwave absorption in the range 5 MHz - 20 GHz and a wide temperature range from - 200 °C and 1,000 °C. The modifications of e.g. 3C-, 4H- and 6H-SiC and differ slightly in their properties and the radiation sources can be matched; the absorption range of 9.7-12.2 MHz is particularly effective. Using a laboratory microwave oven from Fricke and Mallah Microwave Technology GmbH with 5 kW and 2.5 GHz, heating rates of 500 °C sec-1 are achieved in the wafer in a wafer DxH of 100 x 0.32 mm.

### c) Measurement of void and defect volume of a wafer

The volume of the voids 16 including defects 14a created by the laser beam interaction may be determined by absorption measurements in a BET apparatus. A 100 mm SiC wafer having defects 14a and voids 16 is introduced into a slit measurement cell with the inner dimensions of DxH 105 x 1,5 mm with a very low volume of about 135 mL. After degassing in vacuum at 250 °C for 4 h to the end pressure of 1x10⁻⁰⁴ mbar, the cell is immersed into liquid nitrogen and nitrogen is introduced pressure controlled into the cell up to a pressure ratio of 0,97 of inside pressure to laboratory pressure. After equilibration the cell is brought to room temperature: typically, 2 cm³ of gaseous nitrogen STP is released from the filled voids. This corresponds to a theoretical constant slit of 0,25 µm throughout the whole wafer.

### d) Wafer Splitting induced by volume change of separation medium / thermal conditions

### (i) Volume change of condensed nitrogen gas

Commercially available and suitable laser treated SiC wafers (10) (6HC, 4°, 100 mm diameter and 320 µm thickness), are introduced in a slit measuring cell (61) with flat grinding and with internal dimensions of 105 x 105 x 1.5 mm (WxHxD) up to the grinding. The closed cell is connected onto a static, commercial BET measuring device Micromeritics ASAP 2000 via the single measuring tube (63). The measuring cell is baked out at 220 °C in a vacuum up to a final pressure of 1x10-4 mbar; this process typically takes 4-8 h.

After cooling down at ambient temperature under vacuum and removal of the furnace, the slit reactor is slowly immersed in liquid nitrogen and N₂ gas is slowly added up to 950 mbar pressure inside the cell. Typically, 1 mL of N₂ gas STP in addition to the reactor volume minus wafer volume are condensed into the pore structure in narrow gaps < 1 mµ due to the vapor pressure reduction according to the Kelvin-equation. The liquid N₂ bath is removed, the measuring cell below the ground joint is separated under laboratory atmosphere, the cell is turned by hand by approx. 90° so that the still cold wafer, can roll or slide upright in a slot in a heated metal buck with slit (66). The metal block was heated to 350 °C and can be easily handled by hand with pliers. The wafer heats up, the condensed gas vaporizes and creates an internal pressure in the pore system, i.e. the voids. Due to the phase change of liquid to gas a theoretical pressure inside the voids reach about 600 bar: the volume of one mol liquid nitrogen is about 35 mL, and one mol of gaseous nitrogen is 22.4L. The separation can take place with an audible crack and usually is complete. After 10 seconds, the separated wafer slices are rolled or slid out. In cases, if not yet completely separated, the treated wafer is completely separated by mechanical forces, e.g. in a splitting device according to another embodiment of this invention.

### (ii) Volume change of condensed water

Commercially available and suitable laser treated SiC wafers (6HC, 4° cut, 100 mm diameter and 320 µm thickness), are cooled to a temperature below the condensation point of water, preferably -20 °C, more preferably -80 °C, and most preferably -196 °C at ambient pressure of 300 - 1500 mbar, more preferably 600 - 1200 mbar, most preferably 900 - 1100 mbar. The cooling medium can be a gaseous or liquified inert gas, preferably nitrogen, argon, krypton or xenon, or solidified inert gas, preferably carbon dioxide. Other cooling media may be cooled inert organic or inorganic solvents, preferably acetone, propanol, ethanol, butanol, hexane, dichloromethane, dichlorodifluoromethane or other CFCs, and aqueous salt solutions with a melting temperature below the condensation point of water. The cooling of the wafer 10 may be achieved by immersion in the cooling medium, for example in liquid nitrogen until boiling of the cooling medium ceased. Another suitable cooling method may be exposing to an excess stream of the cooling medium. Suitable timespans for the application of the cooling medium are seconds to several minutes, preferably 1 s to 10 min, more preferably 5 s to 5 min, most preferably 10 s to 2 min. After removing the wafer 10 from the cooling medium, the wafer was placed in a saturated water steam atmosphere 34 in an enclosed reactor 32, preferably thermally isolated, with a volume of at least 250 cm³, preferably 500 - 10000 cm³. The saturated water steam atmosphere 34 was created by direct heat application to a water bath 33 with a CARL ROTH digital heating plate C-MAG HP with a heating power of 1500 W. The wafer was exposed to the steam atmosphere for several seconds to minutes, preferably 1 s to 10 min, more preferably 5 s to 5 min, most preferably 10 s to 2 min at ambient pressure, preferably 300 - 1500 mbar, more preferably 600 - 1200 mbar, most preferably 900 - 1100 mbar. The prepared wafer with incorporated water was then placed immediately, preferably in less than one minute, more preferably less than 10 s, in a metal buck 66 with slit (1 mm, 67) preheated to over 100 °C, preferably 100 - 1000 °C, more preferably 200 - 500 °C. The wafer can be transferred manually with pliers or in an automated manner, e.g. by a robotic arm. After about 10 s to 5 min, more preferably 20 s to 2 min, the wafer was removed from the slit from the metal buck. It was evident that the wafer layers had completely separated from one another, resulting in two wafer slices.

### (iii) Spherical front

The 100 mm D wafer (10) is laser-treated so that the traces of the treatment start in one embodiment perpendicular and in another embodiment parallel to the flat 13, Fig. 5).

A fixed base made of aluminium DxH 200 x 50 mm carries on top a CNC-manufactured convex spherical calotte 42 as convex support 42 having an elevation with the dimensions DxH 100 x 0.4 mm as well as guide pins. Above it is a concave spherical calotte with the same dimensions, only concave 41; it can be moved on rails and guide pins perpendicular to the concave surface. A lubricant, preferably nanoscale hexagonal boron nitride, is applied in a layer thickness of 1 µm on both spherical calotte surfaces by squeegee or spray. The wafer 10 is placed between the calottes. The convex part is heated to 250 °C by a heating plate, the concave part 41 is cooled to about - 190 °C by means of liquid nitrogen in a cavity ontop. Then both calottes are brought into contact close contact to the wafer by means of a universal testing machine, no forces are yet applied to the wafer. Then the calottes are moved into each other at a speed of 40 mm min-1 and the wafer adapts to the calottes without breaking. In the time from first contact to flat support, i.e. approx. 0.6 sec, a mechanical tension is applied between the two wafer layers in a ring: I) a mechanical stress of the two layers against each other by bending, and II) a mechanical stress due to the high temperature difference. In both cases, no tensile forces are applied to the frictional (residual) connections in the parting plane but bending or shearing forces. The wafer separates completely at the defect trace in the desired plane 11. The roughness of the cleaved surface is approx. Ra 6 µm. After cleaning the surfaces of boron nitride, the wafer is further processed. If the flexed wafer layers do not completely split off each other, a mechanical lift-off is used to separate the cleaved partial wafers.

### e) Wafer Splitting induced by a mechanical apparatus

### (iv) Apparatus with piston

The wafer (10) is laser-treated so that the traces of the treatment start perpendicular to the flat (13). An anti-adhesive 26 is applied to the edge of the wafer in the flat area 13 by affixing a 5 µm thick paraffin film on the flat area.

The fix support 21 made of aluminium AlMg4,5Mn CNC-manufactured with the dimensions 200 x 110 x 10 mm and a semicircle is drawn with sandpaper 180 and then 280 each 10 times in longitudinal direction over a table edge (each time fresh sandpaper surface). Afterwards, it is cleaned with acetone and ultrasound. The dried surface is sprayed with an activator article # 400200 "Aktivator", HG pro-innovations GmbH (no primer used) The liquid is allowed to flash off at room temperature. The wafer is cleaned with acetone and ultrasound and sprayed with an activator article # 400200 "Aktivator", HG pro-innovations GmbH (no primer used) and left to flash off for 10 minutes. 21 drops with each 0.05 mL of cyanacrylate adhesive HG powerglue article # 200020 purchased by HG pro-innovations GmbH are applied to the fix support 21 in the centre of the bond (area of adhesive 23) which is distributed over a diameter of about 40 mm. The wafer 10 is placed on this adhesive elevation parallel to the surface, taking into account the flat position 13 on the substrate. The capillary force ensures a constant adhesive gap of 40 µm and the adhesive is allowed to cure for 10 min without force.

The flex support 22 with dimensions 200 x 105 x 3.5 mm and a semicircle comprises a modification 24, This area of modification of flex support 24 is a thinning of 1.200 µm in a 12 mm wide strip, in the fracture starting zone. The purpose of the thinning is to achieve a stronger bending in the area of the start of the propagating fracture line. At a load of 40 N at a distance of 60 mm, a curvature of about 2 m in diameter occurs in the short modification zone. The curvature in the remaining adhesive area would be approx. 5 m diameter. The flex support 22 is pre-treated analogous to the fix support 21. In the centre of the split wafer (flexed) 11 surface, which is turned away from the fix support, 15 drops of cyanacrylate adhesive HG powerglue article # 200020 purchased by HG pro-innovations GmbH are applied and the flex support 22 is placed in such a way that the modification zone 24 is parallel to the flat and outside.

After 24 h at room temperature, the fix support 21 is screwed into a holder by means of the mount of fix support 24 in a universal material testing machine and a piston 25 at a distance of 60 mm from the flat presses vertically and centrally on the narrow part of the flexible support 22 (traverse speed 2 mm min-1, force sensor 200 N). After 2 mm movement of the piston the pressure drops from 25 N to 20 N. The break initiation and progress is audible and stops at 20 mm. The fracture line progresses jerkily as the piston moves further and at 4 mm movement of the piston the flexible underpacking separates completely. The result is two slits. The split wafers are removed from the support with acetone.

### (v) Apparatus with roll

The wafer 10 is laser-treated so that the defect traces are perpendicular to the flat 13 . An anti-adhesive 26 is applied to the edge of the wafer in the flat area by affixing a 10 µm thick paraffin film on the flat area.

The fix support 21 made of aluminium AlMg4,5Mn CNC-manufactured with the dimensions 200 x 110 x 10 mm is pulled with sandpaper 180 and then 280 each 10 times in longitudinal direction over a table edge (fresh sandpaper surface in each case). Afterwards, it is cleaned with acetone and ultrasound. The wafer is cleaned with acetone and ultrasound and sprayed with an activator article # 400200 "Aktivator", HG pro-innovations GmbH (no primer used) and left to flash off for 10 minutes. 21 drops with each 0.05 mL of cyanacrylate adhesive HG powerglue article # 200020 purchased by HG pro-innovations GmbH are applied to the fix support 21 in the centre of the bond (area of adhesive 23) which is distributed over a diameter of about 40 mm. The wafer 10 is placed on this adhesive elevation parallel to the surface, taking into account the flat position 13 on the substrate. The capillary force and the dosed volume of adhesive ensures a constant adhesive gap completely under the wafer and it is allowed to cure for 10 min without force.

The flex support 22, steel feeler gauge HOFFMANN tools, with the dimensions 400 x 150 x 0.15 mm is pretreated analogous to the fix support 21. 15 drops of cyanacrylate adhesive HG powerglue article # 200020 purchased by HG pro-innovations GmbH are placed in the centre of the free wafer surface (not yet bonded) and the flex support 22 is placed in such a way that the flat is directed to the long side of the support.

The long side of the flex support 22 is tensioned with a constant force of 30 N by a pneumatic cylinder parallel to the fix support 21. The pressure roller with cardan suspension 28 is placed on the rocking support 27 in front of the flat 13. The approx. 300 mm long flex support 22 is then gradually lifted under tensile stress to create a bend under the swing, still in front of the flat. The rocking support 27 is now unrolled by path control of the guide rail 29 in a universal testing machine (10 mm min-1 travel speed). The initially small radius of 0.75 m in the area of the flat/break starting line changes in a radius of 4 m after 5 mm movement of rocking support under the roll. After approx. 115 mm travel of the guide rail the roll left the wafer area and the wafer is separated.

## Claims

**1.** A method for separating a substrate from a wafer or ingot comprising the following steps:
(i) forming of defects (14a) and resulting voids (16) within the wafer or ingot by means of a laser beam interaction;
(ii) inserting a separation medium into at least parts of the voids (16) including defects (14a);
(iii) effecting a volume change of the separation medium within the voids (16) including defects (14);
(iv) splitting the substrate off the wafer or ingot by means of the volume change of the separation medium.

**2.** The method according to the preceding claim, wherein the laser beam interaction effects in a depth of about 110 µm to about 150 µm, preferably 120 µm to 130 µm, of the wafer or ingot,
defects (14a) having about 2 µm hight and about 8 µm width and
resulting voids (16) of about 10 µm width;
wherein the defects (14a) and the resulting voids (16) build the defect trace (14); and
further parallel defect traces (14), wherein the spacing between parallel defect traces (14) is about 100 µm to 150 µm, wherein
the defect traces (14) are perpendicular to the flat side (13), preferably the defect traces (14) are along one crystallographic plane, and preferably the wafer or ingot has a sharp edge.

**3.** The method according to one of the preceding claims, wherein a total void volume of about 0.5 to 3 mm³, preferably about 0.75 to about 1.5 mm³, more preferably about 0.8 to 1.2 mm³ is effected by laser beam interaction.

**4.** The method according to one of the preceding claims, wherein the substrate, wafer or ingot consists of a crystalline material and is preferably a multi or mono crystalline material, preferably a SiC or Si material, more preferably a SiC material.

**5.** The method according to one of the preceding claims, wherein the separation medium is solid, liquid or gaseous, preferably is condensed water and is expanded to gaseous water vapor or frozen water.

**6.** The method according to one of the preceding claims, wherein the separation medium is inserted by means of diffusion of a gaseous separation medium into the defects (14a) and void (16) of the crystalline material, condensation of a gaseous separation medium into the defects (14a) and void (16) of the crystalline material and/or filling a liquid separation medium into the defects (14a) and void (16) of the crystalline material.

**6.** The method according to one of the preceding claims, wherein the volume change of the separation medium is effected by changing the thermal, aggregate or chemical state of the separation medium.

**7.** The method according to one of the preceding claims, wherein the volume change increases the voids and/or establishes connections between the voids.

**8.** The method according to one of the preceding claims, wherein the separation medium is filled into 50% to 100 % of the voids, preferably 75% to 100%, more preferably 85 to 100%.

**9.** The method according to one of the preceding claims comprising the additional step:
(v) effecting separation of the substrate from the wafer or ingot by a mechanical means.

**10.** A method for separating a substrate from a wafer or ingot comprising the following steps:
(i) forming of defects (14a) and resulting voids (16) within the wafer or ingot by means of a laser beam interaction;
(vi) effecting separation of the substrate from the wafer or ingot by a mechanical force applied in such a manner that the propagating fracture line (20) is in perpendicular alignment to the defect trace(s) (14) and the direction of fracture propagation (20b) is in predominantly parallel alignment to the defect trace(s) (14).

**11.** A method according to claim 10, wherein the wafer or ingot is fixed to a fix support (21) on one side of the wafer or ingot, and to a flex support (22) on the opposite side of the wafer or ingot; preferably by an adhesive.

**12.** A method for separating a substrate from a wafer or ingot comprising the following steps:
(i) forming of defects (14a) and resulting voids (16) within the wafer or ingot by means of a laser beam interaction;
(vii) effecting separation of the substrate from the wafer or ingot by fixing the wafer or ingot between a convex support (42) and a concave support (41) of a spherical calotte;
(viii) moving the convex support (42) and the concave support (41) of the calotte into each other while allowing the wafer or ingot to adapt to the shape of the calotte;
(ix) cooling the concave support (41) of the calotte and at the same time heating the convex support (42) or vice versa.

**13.** An apparatus for separating a substrate from a wafer or ingot comprising
a piston (25);
a fix support (21) having a mount of fix support (21a) and an adhesive area I;
a flex support (22) having a piston application area and an adhesive area II; wherein
the adhesive area I and II are located opposite to each other;
the piston (25) is arranged in such manner that during operation the piston force is applied to the piston application area; and
the wafer or ingot to be separated is affixable between the fix support (21) and the flex support (22) in the respective adhesive areas I and II.

**14.** The apparatus according to claim 13 having a modification of flex support (24) within the flex support (22), wherein the modification of flex support (24) is a **characterized in that** the material is thinner than in the other areas of the flex support 22.

**15.** An apparatus for separating a substrate from a wafer or ingot comprising a fix support (21), preferably on which a wafer or ingot is locally affixable upside;
being connected with a movable table with precision guidance having a guide rail (29); a flex support 22 on which a wafer or ingot is fixable underneath that may be kept under tension by pulling upwards bound in moving direction;
a rocking support (27) between the roll and the flex support (22); and
a pressure roller with cardan suspension (28) located perpendicular on the surface of the fix support (21) and having an axis perpendicular to the moving direction of the guide rail (29)
a frame connecting the fix and flex support with the pressure roller with cardon suspension (28).

**16.** The apparatus according to claims 14 to 15, wherein the wafer or ingot is fixed between the fix support (21) and the flex support (22) in such a manner that the propagating fracture line (20) is in perpendicular alignment to the defect trace(s) (14) and the direction of fracture propagation (20b) is in predominantly parallel alignment to the defect trace(s) (14).

**17.** An apparatus for separating a substrate from a wafer or ingot comprising
a convex support (42) and a concave support (41) of a spherical calotte, wherein
the wafer or ingot to be separated is affixable between the convex support (42) and concave support (41);
the convex support (42) and concave support (41) of the calotte are moveable into each other while allowing the wafer or ingot to adapt to the shape of the calotte; and the concave support (41) of the calotte is coolable and at the same time the convex support (42) is heatable or vice versa.

**18.** An apparatus according claim 18, wherein the spherical calotte has a about 0.4 mm to about 4 mm elevation.

**19.** Use of the substrates of the methods according to claims 1 to 12 for the production of LEDs, high power devices, diodes, discrete and integrated transistors, substrate for epitaxy of SiC material, high-frequency applications, preferably 5G antennas; microwave transmitters or camera lenses.
